# EUROPEAN PATENT APPLICATION

(11) **EP 4 733 780 A2**
(43) Date of publication of application: **29.04.2026**
(21) Application number: 25204956.4
(22) Date of filing: 26.09.2025
(51) Int. Cl.: G01R 31/12, G01R 31/16, G01R 31/385, G01R 31/388, G01R 31/392, H01M 10/42, H01M 10/48, G01R 27/02, G01R 31/389

(54) **JIG FOR MEASURING BREAKDOWN VOLTAGE OF INSULATOR AND MEASURING APPARATUS INCLUDING THE SAME**

(30) Priority: 02.10.2024 KR 20240134185
(71) Applicant: SAMSUNG SDI CO., LTD., Yongin-si, Gyeonggi-do 17084 (KR)
(72) Inventor: SHIN, Eui-Chol, 17084 Yongin-si (KR)
(74) Representative: Maiwald GmbH

(57) **Abstract**

A jig for measuring a breakdown voltage of an insulator includes a support portion accommodating a specimen, support members on the support portion, the support members being connected to the support portion, a first plate connected to the support members, the first plate being movable along the support members, a pressurizing portion connected to a first side of the first plate, the pressurizing portion being configured to apply a pressure to the specimen, and a pressure control portion connected to a second side of the first plate, the pressure control portion being configured to adjust a moving distance of the first plate, wherein the pressurizing portion includes a rod configured to pressurize the specimen, a chuck to which the rod is detachably connected, and a pressure sensor between the chuck and the pressure control portion, the pressure sensor being configured to measure the pressure applied to the specimen.

## Description

### BACKGROUND

### 1. Field

The present disclosure relates to a jig for measuring a breakdown voltage of an insulator and a measuring apparatus including the same.

### 2. Description of the Related Art

Unlike a primary battery that is incapable of being recharged, a rechargeable battery is capable of being repeatedly charged and discharged. A rechargeable battery with a low capacity may be used in a small electronic device that is portable such as a smartphone, a feature phone, a laptop computer, a digital camera, or a camcorder, and a rechargeable battery with a large capacity may be used as a power source for a driving motor of a hybrid vehicles or an electric vehicle, a battery for storing electric power, or the like.

The rechargeable battery may include an electrode assembly having a positive electrode, a negative electrode, and a separator, a case accommodating the electrode assembly, an electrode terminal connected to the electrode assembly, and the like. Because a risk of fire occurs if a short circuit occurs inside the rechargeable battery, an insulating means may be provided in the rechargeable battery.

An insulator may be used as one of the insulating means. The insulator may be coated on a conductive material to block a flow of a current, but if a size of a pressure or a voltage applied to the insulator exceeds a certain level, a portion of the insulator may have conductivity. For example, the insulator may be subject to insulation breakdown, and a voltage applied at a moment when the insulation breakdown occurs is referred to as a breakdown voltage.

If a voltage is applied to the insulator, an electron may ionize an insulating molecule, and an electron additionally generated during the ionization process may ionize another insulating molecule. The insulation breakdown refers to a case in which the insulating molecule of the insulator is exhausted so that the insulator loses insulation as the process is repeated.

### SUMMARY

A jig for measuring a breakdown voltage of an insulator according to an aspect of the present disclosure for solving the technical problem includes: a support portion at which a specimen is disposed; a plurality of support members that are disposed on the support portion and are connected to the support portion; a first plate that is movably connected to the plurality of support members and is capable of being raised or lowered; a pressurizing portion that is connected to one side of the first plate to apply a pressure to the specimen; and a pressure control portion that is connected to the other side of the first plate to adjust a raising or lowering distance of the first plate. The pressurizing portion includes: a rod that pressurizes the specimen; a chuck to which the rod is detachably connected; and a pressure sensor that is disposed between the chuck and the pressure control portion and measures the pressure.

The pressurizing portion may include a heater that surrounds the rod and controls and measures a temperature of the rod.

The pressure control portion may include: a handle; a second plate at which the handle is disposed and connected with the plurality of support members; a bolt that penetrates the second plate and has one side fixedly coupled to the handle; and a fastening member that is connected to the other side of the bolt, is disposed at the other side of the first plate, and is raised or lowered together with the bolt.

The jig may further include: a third plate that is disposed between the first plate and the support portion; and an elastic member that is disposed between the first plate and the third plate and buffers a force that the first plate pushes on the third plate when the first plate is lowered.

The jig may further include a buffer pad that is disposed between the support portion and the specimen and is deformable in a shape.

The specimen may include: a conductive material; and an insulator that is disposed on the conductive material.

The insulator may be made of polyimide or ceramic.

A thickness of the insulator may be 1 µm to 8 µm.

An apparatus for measuring a breakdown voltage of an insulator according to an aspect of the present disclosure includes: a jig for measuring the breakdown voltage of the insulator that includes a pressurizing portion pressurizing a specimen; and a power supply unit that applies a voltage to each of the specimen and the pressurizing portion and measures the applied voltage. The jig for measuring the breakdown voltage of the insulator further includes a first plate that has one side connected to the pressurizing portion and is raised or lowered and a pressure control portion that is connected to the other side of the first plate to adjust a raising or lowering distance of the first plate, and the pressurizing portion includes a rod that pressurizes the specimen, a chuck to which the rod is detachably connected, and a pressure sensor that is disposed between the chuck and the pressure control portion and measures a pressure applied to the specimen by the pressurizing portion.

A rechargeable battery according to an aspect of the present disclosure includes: a first electrode lead that is connected to a first electrode; a second electrode lead that is connected to a second electrode; a separator that is interposed between the first electrode and the second electrode; and at least one of a first insulator coated on at least one of the first electrode lead and the second electrode lead and a second insulator coated on the separator. A thickness of each of the first insulator and the second insulator is 1 µm to 8 µm.

The first insulator may be one of polyimide and ceramic, the thickness of the first insulator may be 3 µm or more if the first insulator is polyimide, and the thickness of the first insulator may be 4 µm or more if the first insulator is ceramic.

The second insulator may be ceramic, and the thickness of the second insulator may be 4 µm or more.

A method for measuring a breakdown voltage of an insulator according to an aspect of the present disclosure includes: a first step of measuring a pressure applied to a specimen by movement of a pressurizing portion; and a second step of measuring a voltage applied to the pressurizing portion and the specimen. The measurement of the first step is performed at a position opposing the specimen based on a longitudinal direction of the pressurizing portion.

A temperature of the pressurizing portion may be controlled before and after the specimen is pressurized.

The second step may boost the voltage applied to the pressurizing portion and the specimen at a constant speed if a size of the measured voltage is 5 V or less and may stop applying the voltage to the pressurizing portion and the specimen if the size of the measured voltage exceeds 5 V.

According to the present disclosure, a pressure applied to an insulator may be more precisely controlled.

According to the present disclosure, a temperature of a portion where a pressure is applied to the insulator may be more precisely controlled.

According to the present disclosure, the above-described precise measurement may be repeatedly performed.

However, an effect that may be obtained through the present disclosure is not limited to the above-described effect, and other technical effects not mentioned may be clearly understood by those skilled in the art from a description of the present disclosure below.

### BRIEF DESCRIPTION OF THE DRAWINGS

Features will become apparent to those of skill in the art by describing in detail exemplary embodiments with reference to the attached drawings, in which:
FIG. 1 is a perspective view of an apparatus for measuring a breakdown voltage of an insulator according to embodiments of the present disclosure;
FIG. 2 is a partial front view of the apparatus for measuring the breakdown voltage of the insulator of FIG. 1;
FIG. 3 is a view showing a state in which a pressurizing portion of the apparatus for measuring the breakdown voltage of the insulator of FIG. 2 pressurizes a specimen;
FIG. 4 is a graph measuring a breakdown voltage of polyimide according to a pressure applied to polyimide when a thickness of polyimide is 1 µm using the apparatus for measuring the breakdown voltage of the insulator of FIG. 1;
FIG. 5 is a graph measuring a breakdown voltage of polyimide according to a pressure applied to polyimide when a thickness of polyimide is 2 µm using the apparatus for measuring the breakdown voltage of the insulator of FIG. 1;
FIG. 6 is a graph measuring a breakdown voltage of polyimide according to a pressure applied to polyimide when a thickness of polyimide is 3 µm using the apparatus for measuring the breakdown voltage of the insulator of FIG. 1;
FIG. 7 is a graph showing a correlation between a pressure applied to ceramic, a thickness of the ceramic, and a breakdown voltage of the ceramic using the apparatus for measuring the breakdown voltage of the insulator of FIG. 1;
FIG. 8 is a perspective view of a wound-type electrode assembly including an insulator; and
FIG. 9 is a perspective view of a stacked-type electrode assembly including an insulator.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. In addition, it will also be understood that when a layer is referred to as being "between" two layers, it can be the only layer between the two layers, or one or more intervening layers may also be present. Like reference numerals refer to like elements throughout.

A term or a word used in the present specification and claims should not be construed as limited to its usual or dictionary meaning, and should be interpreted as a meaning and a concept conforming to a technical idea of the present disclosure based on a principle that an inventor may properly define a concept of the term to describe embodiments in the best way. Thus, the embodiments described in the present specification and a configuration shown in the drawings are only examples of the present disclosure and do not represent all of the technical idea of the present disclosure, so that it should be appreciated that there may be various equivalents and variations that may replace the embodiments and the configuration at a time at which the present application is filed. A term "comprises", "includes", "comprising", or "including" when used in the present specification, specifies presence of a shape, a number, a step, an operation, a member, an element, and/or a group thereof, but does not preclude presence or addition of one or more other shapes, one or more other numbers, one or more other operations, one or more other members, one or more other elements, and/or a group thereof. Further, a use of "may" when the embodiments of the present disclosure described are described refers to "one or more embodiments of the present disclosure".

When it is described that two objects are identical, this means that the objects are "substantially identical". Therefore, the substantially identical objects may include objects having deviations considered low in the art, for example, deviations within 5%. Additionally, when it is described that certain parameters are uniform in a predetermined region, this may mean that the parameters are uniform in terms of an average.

Although terms "first", "second", and the like are used to describe various components, the components are not limited by the terms. The terms are only used to distinguish one component from another component, and unless otherwise stated, the first component may be the second component.

Throughout the specification, unless otherwise stated, each component may be singular or plural.

Disposing any component at an "upper portion (or lower portion)" of or "on (or below)" another component may mean not only that the component is disposed in contact with an upper surface (or a lower surface) of the other component but also that another component may be interposed between the other component and the component disposed on (or below) the other component.

Additionally, when it is described that a component is "connected", "coupled", or "accessed" to another component, the components may be directly connected or accessed to each other, but it should be understood that another component may be "interposed" between the components or the components are "connected", "coupled", or "accessed" through another component. In addition, when one portion is referred to as being electrically coupled or connected to another portion, this includes not only a case where the one portion is directly coupled to the other portion but also a case where the one portion is coupled to the other portion via an intervening element.

Throughout the specification, when referring to "A and/or B", it means A, B, or A and B, unless specifically stated to the contrary. That is, the term "and/or" includes all or any combination of a plurality of items listed. When referring to "C to D", unless otherwise specified, it means that it is greater than or equal to C and less than or equal to D.

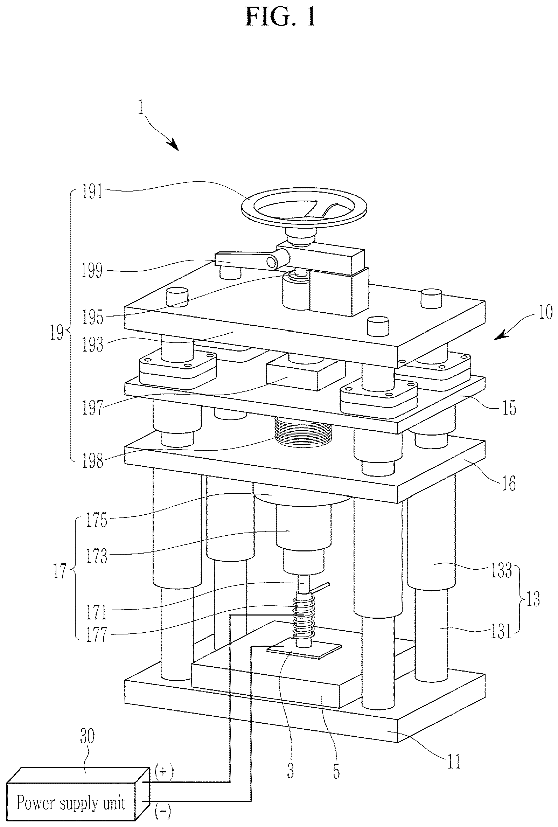

FIG. 1 is a perspective view of an apparatus for measuring a breakdown voltage of an insulator (i.e., a measuring apparatus 1) according to embodiments of the present disclosure. The measuring apparatus 1 may be an apparatus that applies pressure and heat to a specimen 3 and applies voltage to measure the breakdown voltage of the insulator.

Referring to FIG. 1, the measuring apparatus 1 may include a jig 10 for measuring the breakdown voltage of the insulator that applies a pressure and a heat to the specimen 3 and a power supply unit 30 (e.g., a power supplier) that applies a voltage to the jig 10 and the specimen 3 and measures the applied voltage.

The jig 10 may include a support portion 11 (e.g., a supporter) above which the specimen 3 is disposed, a plurality of support members 13, a first plate 15 disposed above the support portion 11 and connected to the support portion 11 by the plurality of support members 13, a pressurizing portion 17 (e.g., a pressurizer) applying pressure to the specimen 3, and a pressure control portion 19 (e.g., a pressure controller) controlling the pressure applied to the specimen 3 by the pressurizing portion 17.

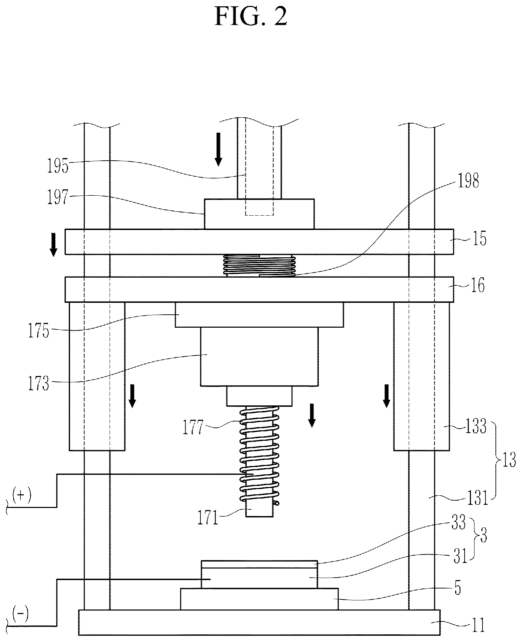

The specimen 3 may include a conductive material 31 and an insulator 33 disposed on the conductive material 31 (see FIG. 2). A detailed description of the specimen 3 will be described later.

The support portion 11 may have a rectangular parallelepiped shape having a flat upper surface so that the specimen 3 is disposed thereon. For example, as illustrated in FIG. 1, the support portion 11 may have a plate shape. For example, the support portion 11 may be configured to display at least one of the pressure applied to the specimen 3 through the pressurizing portion 17 and a temperature of the pressurizing portion 17 on one side thereof.

The plurality of support members 13 may be disposed on the support portion 11, and one side of each support member 13 may be fixedly connected to the support portion 11 and the other side of each support member 13 may be connected to the first plate 15 so that the first plate 15 is movable (e.g., raised or lowered). In embodiments, each of the plurality of support members 13 may be configured so that a portion of a configuration thereof penetrates the first plate 15, e.g., so the first plate 15 may be movable up and down along the support members 13.

Each of the plurality of support members 13 may include a support 131 and a sliding member 133 surrounding the support 131, e.g., the sliding member 133 may be movable along the support 131. The support 131 may have a linear structure extending (e.g., lengthwise and continuously) from the support portion 11 to the first plate 15, and may penetrate the first plate 15.

The sliding member 133 may have a tubular structure disposed around the outer surface of the support 131 and in parallel to the support 131. For example, the sliding member 133 may be between the first plate 15 and the support portion 11 (e.g., the sliding member 133 may be movable between the first plate 15 and the support portion 11). The sliding member 133 may move up and down along the support 131. For example, like the first plate 15, the sliding member 133 may be raised or lowered (e.g., the first plate 15 may be supported on the sliding members 133 while movable along the supports 131). The sliding member 133 may include, e.g., a bearing or an elastic body therein.

The pressurizing portion 17 may apply pressure to the specimen 3 by movement thereof. The pressurizing portion 17 may be connected to one side of the first plate 15, and may be raised or lowered in the same direction as that of the first plate 15 when the first plate 15 is raised or lowered.

The pressurizing portion 17 may include a rod 171 capable of applying a pressure in contact with the specimen 3 when the rod 171 is lowered, a chuck 173 to which the rod 171 is detachably connected, and a pressure sensor 175 that may be disposed between the pressure control portion 19 and the chuck 173 to measure the pressure applied to the specimen 3 by the rod 171. For example, referring to FIG. 1, the chuck 173 may be between the rod 171 and the pressure sensor 175.

For example, the rod 171 may have a shape of a pillar with any suitable cross-sectional shape. The rod 171 may vary in size. The chuck 173 may detachably fix the rod 171 having various shapes and sizes. Accordingly, a user may variously change a shape and a size of a surface in contact with the specimen 3 of the rod 171 by using various types of rods 171, so that an area of the surface that applies a pressure to the specimen 3 is variously adjusted.

The power supply unit 30 may be connected to the rod 171 and the specimen 3. A (+) pole (or a positive pole) of the power supply unit 30 may be connected to the rod 171, and a (-) pole (or a negative pole) of the power supply unit 30 may be connected to the specimen 3. The power supply unit 30 may apply voltage to the components, and may measure the applied voltage.

The power supply unit 30 may boost a voltage applied to the rod 171 and the specimen 3 if a size of the measured voltage is less than or equal to 5 V, and may stop applying the voltage to the rod 171 and the specimen 3 if the size of the measured voltage is greater than 5 V.

The power supply unit 30 may maintain a constant speed increasing the voltage. In embodiments, the power supply unit 30 may boost the voltage at a speed of 10 V/s, and may measure the voltage at an interval of 0.01 s.

Because an insulation breakdown pattern of the insulator varies depending on the boosting speed of the voltage, increasing the voltage at a constant speed may affect precision of measurement of the breakdown voltage.

The pressure sensor 175 may be an apparatus that measures the pressure applied to the specimen 3 by the rod 171. The pressure sensor 175 may be connected to the chuck 173 to measure the pressure applied to the specimen 3 by the rod 171 while being compressed by a repulsive force when the rod 171 applies a pressure to the specimen 3. For example, the pressure sensor 175 may be disposed at a position facing the specimen 3 based on a longitudinal direction of the rod 171 (e.g., a length direction of the rod 171 extending in a direction oriented from the support portion 11 toward the first plate 15) to measure the pressure. In the present embodiment, the pressure sensor 175 may be a load cell.

Because a range of the pressure applied to the specimen 3 by the pressurizing portion 17 is wide, e.g., from 500 Pa to 2 MPa, and a thickness of the specimen 3 (i.e., a measurement target of the jig 10) is in µm units, it is necessary to measure the pressure in more detail (e.g., with more precision) in order to accurately measure the breakdown voltage.

The pressure sensor 175 may be connected to the chuck 173 to measure the pressure at a position facing the specimen 3 based on a longitudinal direction of the pressurizing portion 17, e.g., so the pressure sensor 175 may measure the pressure only at a portion of the specimen 3 facing and contacting an end of the rod 171. Accordingly, because the pressure sensor 175 only needs to calculate the pressure applied to the specimen 3 by the rod 171 when the pressure is measured, the measurement value may have increased accuracy. In other words, since the pressure sensor 175 is connected to the chuck 173, a smaller number of errors may occur during pressure measurement, compared with a pressure sensor connected to a surface supporting the specimen 3 (e.g., the support portion 11). For example, if the pressure sensor 175 were to be connected directly to the support portion 11 supporting the specimen 3, the pressure sensor 175 would have calculated a pressure applied to an upper surface of the support portion 11 (rather than a pressure only at a surface where the rod 171 is in contact with the specimen 3), thereby generating an error in the measurement value.

The pressurizing portion 17 may further include a heater 177 connected to the rod 171 to control a temperature of the rod 171. For example, referring to FIG. 1, the heater 177 may have a shape of a heating wire wrapped around an outer surface of the rod 171. The heater 177 may include a function of a temperature sensor capable of measuring a temperature.

In another example, the heater 177 may have a shape of a heater jacket wrapped around an outer surface of the rod 171 with cotton. For example, the heater 177 may have a structure in which a heating wire is accommodated inside a cover including an inner casing or covering and an outer casing or covering, with the inner casing or covering wrapping around an outer surface of the rod 171.

The heater 177 may be connected to the rod 171 that applies a pressure to the specimen 3 to precisely control a temperature of an area of the specimen 3 to which the pressure is applied before and after the specimen 3 is pressurized. Therefore, the jig 10 according to embodiments of the present disclosure may more accurately and consistently measure the breakdown voltage of the insulator by controlling a pressure and a temperature applied to the specimen 3 by the pressurizing portion 17 that applies a pressure to the specimen 3.

The pressure control portion 19 may be configured to control the pressure applied to the specimen 3 by the pressurizing portion 17, may be connected to the other side of the first plate 15, and may control a moving distance (e.g., a raising or lowering distance) of the pressurizing portion 17. For example, referring to FIG. 1, the pressure control portion 19 and the pressurizing portion 17 may be on opposite sides (e.g., surfaces) of the first plate 15.

The pressure control portion 19 may include a handle 191 determining whether a pressure is applied and a degree of application of the pressure, a second plate 193 at which the handle 191 is disposed, and a bolt 195 having one side connected to the handle 191 and penetrating the second plate 193. For example, referring to FIG. 1, the second plate 193 may be parallel to the first plate 15, and the handle 191 and the bolt 195 may be on a surface of the second plate 193 facing away from the first plate 15.

If the handle 191 is rotated in a first direction, the first plate 15 and the pressurizing portion 17 may be lowered (e.g., relative to the support portion 11) toward the specimen 3, and the rod 171 may be in contact with the specimen 3 to apply the pressure to the specimen 3. If the handle 191 is rotated in a second direction (opposite the first direction), the first plate 15 and the pressurizing portion 17 may be raised (e.g., relative to the support portion 11) in a direction oriented away from the specimen 3.

The handle 191 may be disposed at a center of an upper surface of the second plate 193 (e.g., the surface of the second plate 193 facing away from the first plate 15). If the handle 191 is disposed at one side of the upper surface of the second plate 193, the handle 191 and a point symmetrical thereto may be connected by a conveyor belt, so that a surface of the first plate 15 is uniformly raised or lowered according to rotation of the handle 191.

The second plate 193 may be connected to and fixed to the other side of each of the plurality of support members 13. For example, the second plate 193 may not be raised or lowered (e.g., the second plate 193 may be stationary). The bolt 195 penetrating the second plate 193 may have a first end fixedly coupled to the handle 191 and a second end coupled to a fastening member 197 (e.g., the bolt 195 may be connected to the fastening member 197 at a surface of the second plate 193 facing the first plate 15). The bolt 195 and the second plate 193 may be screw-coupled.

For example, referring to FIG. 1, a first surface of the fastening member 197 may be flat and in contact with the first plate 15, and a second surface of the fastening member 197 may be in contact with the bolt 195. The bolt 195 may be movable through the second plate 193 to move the first plate 15 via the fastening member 197.

If the handle 191 is rotated in the first direction (e.g., to lower the first plate 15), the bolt 195 may be lowered by rotating while the second plate 193 remains fixed, causing the fastening member 197 connected to the bolt 195 to also lower and push against the first plate 15. Accordingly, the first plate 15 may be lowered.

In another example, the other side of the bolt 195 may not be coupled to the fastening member 197, and the bolt 195 may penetrate the first plate 15. In this case, the bolt 195 may not be screw-coupled to the second plate 193, the bolt 195 may be screw-coupled to the first plate 15, and the first plate 15 may be raised or lowered when the bolt 195 rotates.

The pressure control portion 19 may further include an elastic member 198 disposed between the first plate 15 and the pressurizing portion 17. When the first plate 15 is lowered, the elastic member 198 may buffer a force that the first plate 15 pushes on the pressurizing portion 17. Therefore, when the pressurizing portion 17 is lowered through the pressure control portion 19, it is possible to prevent the pressurizing portion 17 from being lowered too rapidly.

The elastic member 198 may be compressed as the first plate 15 is lowered. The compressed elastic member 198 may raise the first plate 15 while expanding by an elastic force.

The pressure control portion 19 may further include a locking lever 199. The pressure control portion 19 may use the locking lever 199 to maintain a pressure in a state in which the pressurizing portion 17 applies the pressure to the specimen 3. The locking lever 199 may be connected to the handle 191 and may prevent the handle 191 from being released due to a repulsive force against a pressure applied to the specimen 3, the elastic force of the elastic member 198, and the like to maintain the pressure applied to the specimen 3 by the pressurizing portion 17.

The jig 10 may include a third plate 16 disposed between the first plate 15 and the support portion 11. In this case, the elastic member 198 may be disposed between the first plate 15 and the third plate 16. The elastic member 198 may buffer a force that the first plate 15 pushes on the third plate 16 to adjust a raising or lowering distance of the third plate 16 in more detail.

The elastic member 198 may rotate the handle 191 in the first direction so that the elastic member acts as a buffer when the pressurizing portion 17 is lowered to be in contact with the specimen 3 so that the pressure is applied to the specimen 3. Thus, the elastic member 198 may partially reduce the pressure applied to the specimen. Therefore, the pressure control portion 19 may allow the pressurizing portion 17 to apply the pressure to the specimen 3 in more detail through the elastic member 198.

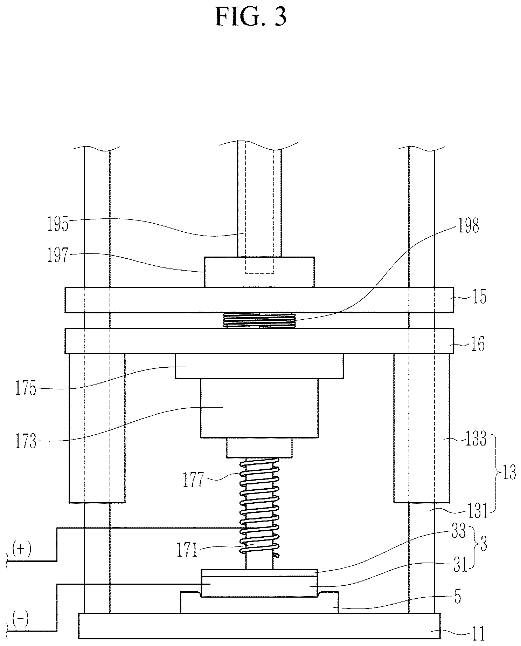

Each of FIG. 2 and FIG. 3 is a view describing an operation process of the jig 10. FIG. 2 is a partial, enlarged front view of the jig 10 of FIG. 1 (before lowering), and FIG. 3 is a view showing a state in which the pressurizing portion 17 of FIG. 2 is lowered to pressurize (e.g., press) the specimen 3. For convenience, the power supply unit, the handle, the locking lever, and the second plate are omitted in FIGS. 2 and 3.

Referring to FIG. 2 and FIG. 3, the specimen 3 may include the conductive material 31 and the insulator 33 disposed on the conductive material 31. The conductive material 31 may refer to a material capable of conducting electricity, and the insulator 33 may refer to a material that blocks a flow of electricity. The specimen 3 may be positioned on a buffer pad 5 on the support portion 11.

The conductive material 31 of the specimen may face the buffer pad 5, and the insulator 33 may be coated on the conductive material 31 to face the pressurizing portion 17 and to block a flow of a current between the rod 171 and the conductive material 31. The insulator 33 may be one of, e.g., polyimide and ceramic. The ceramic may be, e.g., boehmite.

The power supply unit 30 may connect a (+) pole (or a positive pole) to the rod 171, and may connect a (-) pole (or a negative pole) to the conductive material 31, and may apply electric power. The insulator 33 may block the flow of the current between the rod 171 and the conductive material 31.

The insulator 33 may be subject to insulation breakdown by a voltage increase of the power supply unit, and a voltage at a moment when a current flows between the insulator 33 and the rod 171 despite a disposition of the insulator 33 may be referred to as a breakdown voltage of the insulator 33.

Polyimide may be coated on an electrode lead, and ceramic may be coated on one of an electrode lead, a separator, and a negative electrode mixture. A thickness for having the same breakdown voltage when the same pressure is applied to the insulator 33 of polyimide may be thinner than that of ceramic.

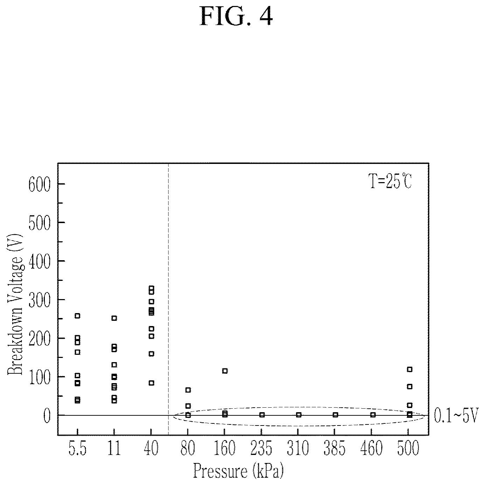

A particle disposition of polyimide may be denser than that of ceramic so that there are fewer gas molecules to be ionized when a voltage is applied to polyimide. However, gas molecules that are easily ionized may exist in a void between ceramic powders in ceramic. Thus, a probability of insulation breakdown of ceramic may be higher than that of polyimide so that the breakdown voltage is lower compared with the same thickness in ceramic. Data verifying this may be confirmed with reference to FIGS. 4 to 7.

The specimen 3 may be disposed on the buffer pad 5. The buffer pad 5 may be made of a material that is easily deformed if an external force is applied to the buffer pad 5 so that it evenly adjusts a pressurizing area when the specimen 3 is pressurized by the pressurizing portion 17.

In embodiments, the buffer pad 5 may be a silicon pad. The buffer pad 5 may help the jig 10 measure the breakdown voltage of the insulator 33 more accurately by evenly adjusting a pressurizing area of the insulator 33.

If the specimen 3 is disposed above the support portion 11, the pressure control portion 19 may push the first plate 15 to lower the first plate 15 and the pressurizing portion 17. If the handle 191 of FIG. 1 is rotated in the first direction (e.g., a clockwise direction), the bolt 195 having one side fixedly coupled to the handle 191 may be rotated in the same direction.

The bolt 195 may be lowered along a screw line while rotating. As the bolt 195 is lowered, the fastening member 197 connected to the other side of the second plate 193 may be lowered together. The fastening member 197 may push the first plate 15 in contact with one surface thereof so that the first plate 15 is lowered.

If the bolt 195 penetrates the first plate 15, the bolt 195 may be screw-coupled to the first plate 15. If the bolt 195 rotates in the first direction, the first plate 15 may be lowered along the screw line of the bolt 195.

If the first plate 15 is lowered, the sliding member 133 of the support member 13 may also be lowered. The sliding member 133 may prevent the first plate 15 from being excessively lowered by including the elastic body and the like therein.

The elastic member 198 disposed between the first plate 15 and the pressurizing portion 17 may be compressed by a force that the first plate 15 pushes on the pressurizing portion 17, and may push the first plate 15 with a repulsive force to partially conflict the force that the first plate 15 pushes on the pressurizing portion 17. Accordingly, it is possible to prevent the pressurizing portion 17 from being excessively lowered.

If the handle 191 of FIG. 1 is rotated in the second direction (e.g., a counterclockwise direction) to lower the pressure, the bolt 195 and the fastening member 197 may be raised not to be in contact with the first plate 15, and the elastic member 198 may be expanded by an elastic force to raise the first plate 15 by a separation distance between the fastening member 197 and the first plate 15.

The power supply unit may apply a voltage to the rod 171 and the conductive material 31 by lowering of the pressurizing portion 17 in a state in which the rod 171 is in contact with the insulator 33. The pressurizing portion 17 may apply a heat to the rod 171 via the heater 177 before and after the rod 171 pressurizes the insulator. The heater 177 may immediately measure a temperature of the rod 171 by including a function of a temperature sensor, so that it more precisely controls the temperature of the rod 171.

Each of FIGS. 4 to 6 is a graph measuring a breakdown voltage of polyimide according to a pressure applied to polyimide for each thickness using the measuring apparatus 1 according to embodiments of the present disclosure.

If the breakdown voltage of the insulator is 0.1 V to 5 V in the graph, it may be considered that the insulation is broken down. For example, the insulator may be an insulator capable of being stably insulated only when the breakdown voltage is at least 5 V at a specific pressure.

The breakdown voltage of the insulator may be proportional to a thickness of the insulator, so that the thickness of the insulator needs to be thicker in order for the insulator to withstand a high pressure and be stably insulated.

FIG. 4 is a graph measuring the breakdown voltage while applying various pressures to polyimide with a thickness of 1 µm. Referring to FIG. 4, it may be confirmed that the breakdown voltage is within 0.1 V to 5 V if a pressure applied to polyimide is 80 kPa or more. Therefore, it may be seen that polyimide of 1 µm is stably insulated only in an environment where a pressure of less than 80 kPa is applied.

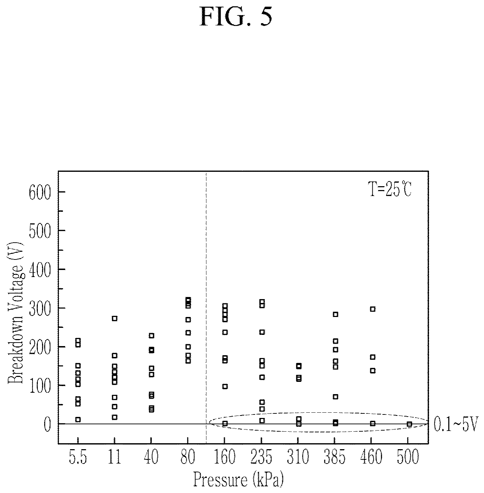

FIG. 5 shows measurement data when a thickness of polyimide is 2 µm. Referring to FIG. 5, unlike a case in which the thickness of polyimide is 1 µm, it may be confirmed that the breakdown voltage thereof exceeds 5 V when a pressure applied to polyimide is 80 kPa. However, it may be confirmed that the breakdown voltage is within 0.1 V to 5 V at 160 kPa or more, so that it may be seen that the thickness of polyimide should exceed 2 µm to withstand a pressure of 160 kPa or more.

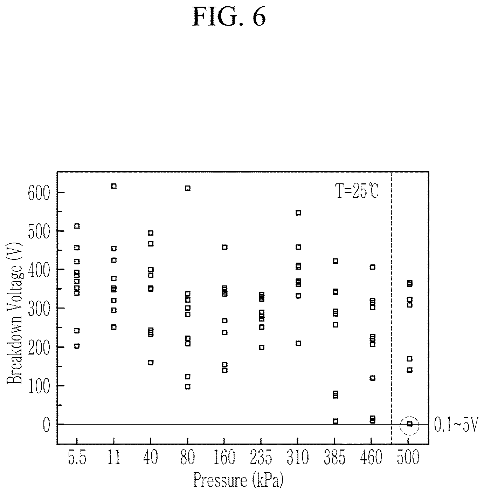

FIG. 6 shows measurement data when a thickness of polyimide is 3 µm. Referring to FIG. 6, it may be confirmed that the breakdown voltage thereof exceeds 5 V when a pressure applied to polyimide is less than 500 kPa. Therefore, if polyimide of 3 µm is used, it may be confirmed that polyimide withstands a pressure of less than 500 kPa.

It may be seen that the thickness of polyimide should be at least 3 µm in terms of stability because a pressure applied to a rechargeable battery in a specific situation (e.g., thermal runaway) is about 500 kPa and the insulator is a means (or a device) for safety.

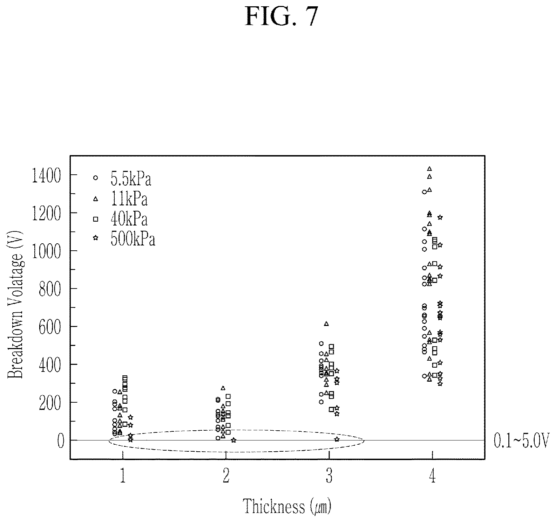

FIG. 7 is a graph showing a correlation between a pressure applied to ceramic, a thickness of the ceramic, and a breakdown voltage of the ceramic that are measured using the measuring apparatus 1 according to embodiments of the present disclosure.

Referring to FIG. 7, if the pressure applied to the ceramic is 500 kPa and the thickness of the ceramic is less than 3 µm, the breakdown voltage may be within 0.1 V to 5 V, so that it may be seen that the thickness of the ceramic should be at least 4 µm. The ceramic may be boehmite.

If the result values of FIG. 4 to FIG. 7 are summarized, when a pressure applied to the insulator is at least 500 kPa, it may be seen that a thickness of polyimide that is the insulator should exceed 3 µm so that the breakdown voltage thereof is 5 V or more and a thickness of ceramic that is the insulator should be 4 µm or more so that the breakdown voltage thereof is 5 V or more.

For example, according to the jig 10 according to embodiments of the present disclosure, the breakdown voltage of the insulator may be repeatedly measured under the same condition, and a temperature and a pressure applied to the insulator may be adjusted in more detail (e.g., with more precision). Thus, even if a thickness of the insulator is thin, the accurate result described above may be obtained.

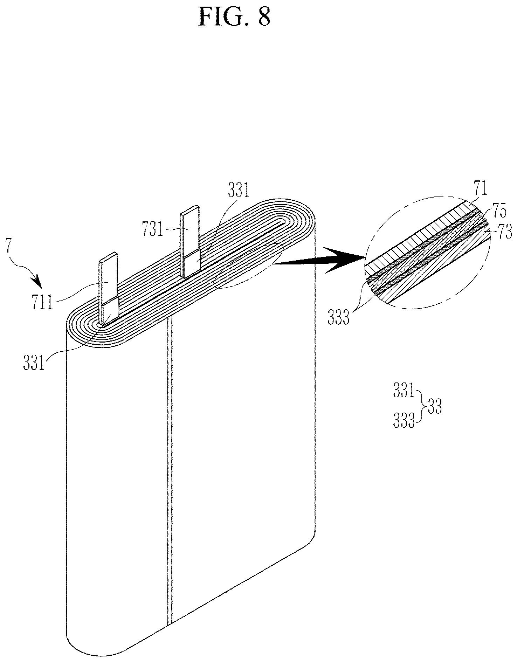

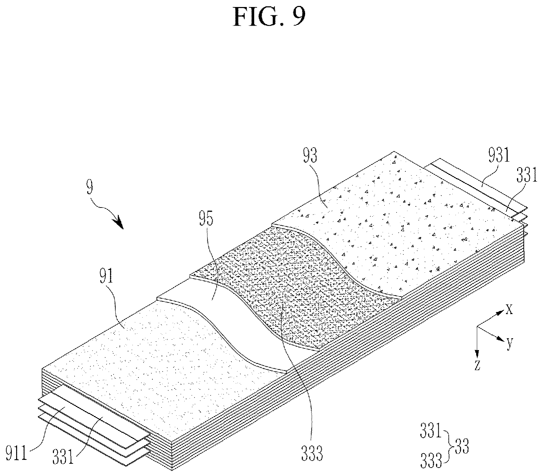

FIG. 8 is a perspective view of a wound-type electrode assembly 7 including the insulator 33, and FIG. 9 is a perspective view of a stacked-type electrode assembly 9 including the insulator 33.

Referring to FIG. 8, the wound-type electrode assembly 7 may include a first electrode 71, a second electrode 73, and a separator 75 interposed therebetween, and may have a structure in which the first electrode 71, the second electrode 73, and the separator 75 are wound in a state in which the first electrode 71 and the second electrode 73 are stacked with the separator 75 interposed therebetween.

The first electrode 71 and the second electrode 73 may be each connected to a first electrode lead 711 and a second electrode lead 731, respectively. A first insulator 331 may be coated on one of the first electrode lead 711 and the second electrode lead 731. A second insulator 333 may be coated on the separator 75. Thicknesses of the first insulator 331 and the second insulator 333 may be 1 µm to 8 µm.

The first insulator 331 may be one of polyimide and ceramic. If the first insulator 331 is polyimide, the thickness of the first insulator 331 may be 3 µm or more, and if the first insulator 331 is ceramic, the thickness of the first insulator 331 may be 4 µm or more. The second insulator 333 may be ceramic. The thickness of the second insulator 333 may be 4 µm or more.

Referring to FIG. 9, the stacked-type electrode assembly 9 may have the same structure and configuration as those of the wound-type electrode assembly 7 except for a shape that is not wound in a state in which a first electrode 91, a second electrode 93, and a separator 95 interposed therebetween are stacked. Therefore, a description of the stacked-type electrode assembly 9 overlapping the wound-type electrode assembly 7 will be omitted, and a difference between the stacked-type electrode assembly 9 and the wound-type electrode assembly 7 will be mainly described.

In the stacked-type electrode assembly 9, a first electrode lead 911 connected to the first electrode 91 may protrude in a length direction (e.g., an X-axis direction based on FIG. 9) of the first electrode 91, and a second electrode lead 931 connected to the second electrode 93 may protrude in a length direction (e.g., the X-axis direction based on FIG. 9) of the second electrode 93 and may protrude in a direction opposite to the protruding direction of the first electrode lead 911. The first insulator 331 may be coated on each of the electrode leads 911 and 931.

The first insulator 331 may be one of polyimide and ceramic, and if the first insulator 331 is polyimide, a thickness thereof may be 3 µm or more, and if the first insulator 331 is ceramic, a thickness thereof may be 4 µm or more. However, the first insulator 331 may be less than or equal to 8 µm. The ceramic may be boehmite.

The separator 95 of the stacked-type electrode assembly 9 may be coated with the second insulator 333. For example, the second insulator 333 may be entirely coated on one surface of the separator 95. In FIG. 9, for convenience, the second insulator 333 is shown as being coated on one surface of the separator 95, but the second insulator 333 may be coated on both surfaces of the separator 95. The second insulator 333 may be ceramic, and a thickness of the second insulator 333 may be 8 µm or less and 4 µm or more.

Each of the electrode assemblies 7 and 9 may improve stability and may have a high energy density by including the insulator 33 having a thickness optimized for an operation environment of each of the electrode assemblies 7 and 9.

By way of summation and review, a breakdown voltage of an insulator may be proportional to a thickness of the insulator. For example, because the insulator may have many insulating molecules therein as the insulator is thick, the breakdown voltage may increase as the insulator is thickened.

However, because a space available inside a rechargeable battery is limited and the insulator is not a material directly related to an energy capacity, setting the thickness of the insulator too thick may be disadvantageous in terms of the energy capacity. Considering this, it may be desirable in terms of an energy density to select an appropriate thickness of the insulator.

In order to select the appropriate thickness of the insulator, an apparatus measuring the breakdown voltage of the insulator needs to be precise. An insulation resistance of the insulator may vary depending on a pressure and a voltage applied to the insulator. Thus, if the pressure and the voltage are not precisely controlled when the breakdown voltage is measured, the measurement value may differ.

For example, as a pressure or a temperature applied to the insulator increases, the insulation resistance may decrease so that the breakdown voltage is measured to be low. In some embodiments, if a pressure or a temperature actually applied to the insulator is different from an input value even if the measurement is performed under the same condition, the measurement value may not be uniformly measured.

If a thickness of the insulator to be measured is thin in micrometers, the breakdown voltage may respond more sensitively to the applied pressure or temperature. Therefore, when the breakdown voltage is measured, it may be desirable to precisely control the pressure or the temperature applied to the insulator.

Therefore, the present disclosure provides a jig for measuring a breakdown voltage of an insulator capable of more precisely measuring a breakdown voltage of an insulator.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated.

## Claims

1. A jig (10) for measuring a breakdown voltage of an insulator (33), the jig (10) comprising:
a support portion (11) accommodating a specimen (3);
support members (13) on the support portion (11), the support members (13) being connected to the support portion (11);
a first plate (15) connected to the support members (13), the first plate (15) being movable along the support members (13);
a pressurizing portion (17) connected to a first side of the first plate (15), the pressurizing portion (17) being configured to apply a pressure to the specimen (3); and
a pressure control portion (19) connected to a second side of the first plate (15), the pressure control portion (19) being configured to adjust a moving distance of the first plate (15),
wherein the pressurizing portion (17) comprises:
a rod (171) configured to pressurize the specimen (3),
a chuck (173) to which the rod (171) is detachably connected, and
a pressure sensor (175) between the chuck (173) and the pressure control portion (19), the pressure sensor (175) being configured to measure the pressure applied to the specimen (3).

2. The jig (10) as claimed in claim 1, wherein the pressurizing portion (17) further comprises a heater (177) that surrounds the rod (171), the heater (177) being configured to control and measure a temperature of the rod (171).

3. The jig (10) as claimed in claim 1 or 2, wherein the pressure control portion (19) comprises:
a handle (191);
a second plate (193) connected to the support members (13), the handle (191) being on the second plate (193);
a bolt (195) that penetrates the second plate (193), the bolt (195) having a first end fixedly coupled to the handle (191); and
a fastening member (197) connected to a second end of the bolt (195), the fastening member (197) being at the second side of the first plate (15), and the fastening member (197) being movable together with the bolt (195).

4. The jig (10) as claimed in any one of the preceding claims, further comprising:
a third plate (16) between the first plate (15) and the support portion (11); and
an elastic member (198) between the first plate (15) and the third plate (16), the elastic member (198) being configured to buffer a force that the first plate pushes on the third plate (16) when the first plate (15) is lowered.

5. The jig (10) as claimed in any one of the preceding claims, further comprising a buffer pad (5) between the support portion (11) and the specimen (3), the buffer pad (5) being deformable.

6. The jig (10) as claimed in any one of the preceding claims, wherein the specimen (3) comprises:
a conductive material (31); and
an insulator (33) on the conductive material (31).

7. The jig (10) as claimed in claim 6, wherein the insulator (33) comprises polyimide or ceramic.

8. The jig (10) as claimed in claim 7, wherein a thickness of the insulator (33) is 1 µm to 8 µm.

9. An apparatus (1) for measuring a breakdown voltage of an insulator (33), the apparatus (1) comprising:
a jig (10) for measuring the breakdown voltage of the insulator (33), the jig (10) comprising
a pressurizing portion (17) configured to pressurize a specimen (3), the pressurizing portion (17) comprising:
a rod (171) configured to pressurize the specimen (3),
a chuck (173) to which the rod (171) is detachably connected, and
a pressure sensor (175) on the chuck (173), the pressure sensor (175) being configured to measure a pressure applied to the specimen (3) by the pressurizing portion (17),
a first plate (15) having a first side connected to the pressurizing portion (17), the first plate (15) being movable, and
a pressure control portion (19) connected to a second side of the first plate (15), the pressure control portion (19) being configured to adjust a moving distance of the first plate (15), and the pressure sensor (175) being between the chuck (173) and the pressure control portion (19); and
a power supply unit (30) configured to apply a voltage to each of the specimen (3) and the pressurizing portion (17), the power supply unit (30) being configured to measure an applied voltage.

10. A rechargeable battery, comprising:
a first electrode lead (711, 911) that is connected to a first electrode (71, 91);
a second electrode lead (731, 931) that is connected to a second electrode (73, 93);
a separator (75, 95) between the first electrode (71, 91) and the second electrode (73, 93); and
an insulator (33) coated on at least one of the first electrode lead (711, 911), the second electrode lead (731, 931), and the separator (75, 95), a thickness of the insulator (33) being 1 µm to 8 µm.

11. The rechargeable battery as claimed in claim 10, wherein:
the insulator (33) comprises a first insulator (331) coated on at least one of the first electrode lead (711, 911) and the second electrode lead (731, 931),
the first insulator (331) is polyimide or ceramic, and
a thickness of the first insulator (331) is 3 µm or more if the first insulator (331) is polyimide, and a thickness of the first insulator (331) is 4 µm or more if the first insulator (331) is ceramic.

12. The rechargeable battery as claimed in claim 10 or 11, wherein:
the insulator (33) comprises a second insulator (333) coated on the separator (75, 95),
the second insulator (333) is ceramic, and
a thickness of the second insulator (333) is 4 µm or more.

13. A method for measuring a breakdown voltage of an insulator (33), the method comprising:
measuring a pressure applied to a specimen (3) by movement of a pressurizing portion (17), measuring the pressure being performed at a position opposing the specimen (3) based on a longitudinal direction of the pressurizing portion (17); and
measuring a voltage applied to the pressurizing portion (17) and the specimen (3).

14. The method as claimed in claim 13, further comprising controlling a temperature of the pressurizing portion (17) before and after the specimen (3) is pressurized.

15. The method as claimed in claim 13 or 14, wherein measuring the voltage comprises:
boosting the voltage applied to the pressurizing portion (17) and the specimen (3) at a constant speed if a measured voltage is 5 V or less, and
stopping the voltage applied to the pressurizing portion (17) and the specimen (3) if the measured voltage exceeds 5 V.
